Europäisches Patentamt

European Patent Office

Office européen des brevets

(11) Publication number: **0 371 901**
**A2**

## (12) EUROPEAN PATENT APPLICATION

(21) Application number: **89480150.5**

(22) Date of filing: **26.09.89**

(51) Int. Cl.⁵: **H01L 21/22**

(30) Priority: **18.10.88 US 259377**

(43) Date of publication of application:
**06.06.90 Bulletin 90/23**

(84) Designated Contracting States:
**DE FR GB**

(71) Applicant: **International Business Machines Corporation**
**Old Orchard Road**
**Armonk, N.Y. 10504(US)**

(72) Inventor: **Silvestri, Victor Joseph**
**3 Beverly Court**
**Hopewell Junction, N.Y. 12533(US)**

(74) Representative: **Klein, Daniel Jacques Henri**
**Compagnie IBM France Département de Propriété Intellectuelle**
**F-06610 La Gaude(FR)**

(54) **Thick epitaxial films with abrupt junctions.**

(57) An improved process for depositing single crystal epitaxial films of silicon is disclosed herein. The resulting epitaxial film is comprised of a combination of a thin (100Å) low temperature (less than 800°C) epitaxial layer (36) followed by a deposition of a medium temperature (greater than 800°C) epitaxial layer (38) growth to the desired thickness. The low-temperature epitaxial silicon layer provides abrupt defined regions of conductivity while the medium temperature epitaxial layer provides a thicker layer at greater deposition efficiency.

FIG. 1

# THICK EPI FILMS WITH ABRUPT JUNCTIONS

This invention relates to the deposition of epitaxial silicon layers in semiconductor devices and more particularly to a method for growing epitaxial silicon films with minimal autodoping using low temperature epitaxial film growth followed by a higher temperature epitaxial film growth.

In the ever continuing effort to reduce the dimensions of high performance integrated circuitry, certain device parameters have been limited by the processes available to fabricate these parameters. One such parameter is the thickness of the epitaxial film deposited on doped substrates. Because of autodoping problems of the epitaxial layer caused by vapor out-gassing of impurities from the substrate into said layer, the dimensions of these layers deposited by silicon epitaxy have been limited to magnitudes greater than the thickness required to overcome the out-gassed dopants. This length is about 1 micron under conventional (T is greater than 1000°C) processing conditions. The incorporation of these out-gassed dopants has similarly prevented the formation of abrupt dopant transition widths.

In the past various solutions have been proposed for overcoming these autodoping problems. For instance, in U.S. Patent No. 3,660,180, issued on May 2, 1972 to Wajda, autodoping is taught to be minimized by sputtered deposition of a first film on a doped semiconductor substrate followed by a conventional epitaxial deposition. However, sputtered films are known to be unacceptable for use as epitaxial depositions. For instance, sputtered films cause considerable surface damage during their deposition. This surface damage is repeated in subsequent crystal growth. Sputtered layers would also be of a different crystallographic lattice orientation than the substrate causing dislocation and growth deformities. In addition, sputtering is highly contaminating and unacceptable for use with large area epitaxial growth.

Therefore, the skill in the art was such that chemical vapor deposition (CVD) was the preferred epitaxial deposition process in which CVD processes were typically performed at temperatures above 1000°C.

As an improvement in CVD techniques, practitioners have investigated and are continuing in the development of low temperature silicon epitaxy. Processing at temperatures in these lower temperature ranges (T is less than 1000°C) enable the practitioner to control the doping and auto-doping problems in the epitaxial silicon known to be encountered with processing at the higher temperatures. See for example: S. Nakanuma "Silicon Variable Capacitance Diodes With High Voltage Sensitivity By Low Temperature Epitaxial Growth Cite" (Paper presented in part at the 1965 Electrochemical Society meeting, San Francisco, California); D. C. Gupta "Improved Methods of Depositing Vapor-Phase Homoepitaxial Silicon" Solid State Technology, October 1971, pp. 33-39; and R. N. Thomas, M. H. Francombe "Low Temperature Epitaxial Growth of PN Junction By UHV Sublimation" Applied Physics Letters, Volume 13, Number 8, October, 1968, pp. 270-272.

As a recent example of the advances being made in low temperature epitaxial film growth, homoepitaxial silicon layer depositions of high crystalline perfection at low temperatures are described by B. S. Meyerson, Applied Physics Letters 48 (12) 797-799 (1986). This article demonstrates the deposition of epitaxial silicon films on wafers by techniques at temperatures in the range of 700°C to 850°C. Processing in such temperature range resulted in abrupt dopant transitions with boron doping levels dropping four orders of magnitude $10^{19}$ to $10^{15}$ B/Cm3 in the first 1000Å of an intrinsic epilayer with a 4000-6000Å epilayer deposit.

In addition, spectra analysis of the epitaxial layers found the deposit to be identical to those of the bulk crystal and without any hidden crystallographic defects. Thus, low temperature silicon epitaxy seems to offer a significant advance over previously practiced deposition techniques.

However, processing times for low-temperature silicon epitaxy depositions are comparatively long. Typical deposition rates with low-temperature epitaxy are about 50Å - 150Å per minute. This makes the process inefficient and unacceptable to use with films in the range of 1 micron or larger.

It is, therefore, an object of the present invention to provide a method for epitaxial depositions on silicon wafers wherein out diffusion, and/or autodoping from the wafer can be contained to minimum diffusion lengths.

It is a further object of the present invention to provide a method for epitaxial deposition on silicon wafers wherein autodoping can be contained and relatively thick (greater than 1 micron) depositions can be obtained in short processing times.

It is a still further object of the present invention to provide a method and structure for first depositing a low-temperature epitaxial layer followed by a second deposition of medium to high temperature epitaxial growth.

According to the present invention, a method for the deposition of epitaxial films (greater than 1 micron) with abrupt junctions at the substrate surface interface is disclosed herein. The method comprises depositing onto a substrate a first layer of epitaxial growth wherein said first layer of epitaxial growth is deposited at temperatures less than 800° C with a total base pressure less than about $10^{-8}$ Torr. This first layer is of thickness greater than 100Å.

Onto said first layer is then deposited a second layer of epitaxial growth said second layer of epitaxial growth is deposited by conventional techniques at temperatures greater than 800° C. The thickness of said second layer being greater than or equal to the thickness of said first layer.

The foregoing and other objects, features, and advantages of the invention will be apparent from the following more particular description of the invention, in conjunction with the accompanying drawings.

Figure 1 is a cross-section view of a semiconductor substrate with low-temperature and high-temperature epitaxial growth deposited thereon.

Figure 2 is a layout plan for one type of low-temperature low-pressure epitaxial growth apparatus.

Figures 3A and 3B are Secondary Ion Mass Spectrometry (SIMS) curves for conventional high-temperature epitaxial growth on a doped substrate.

Figures 4A and 4B are SIMS curves for the epitaxial layer growth of Figure 1.

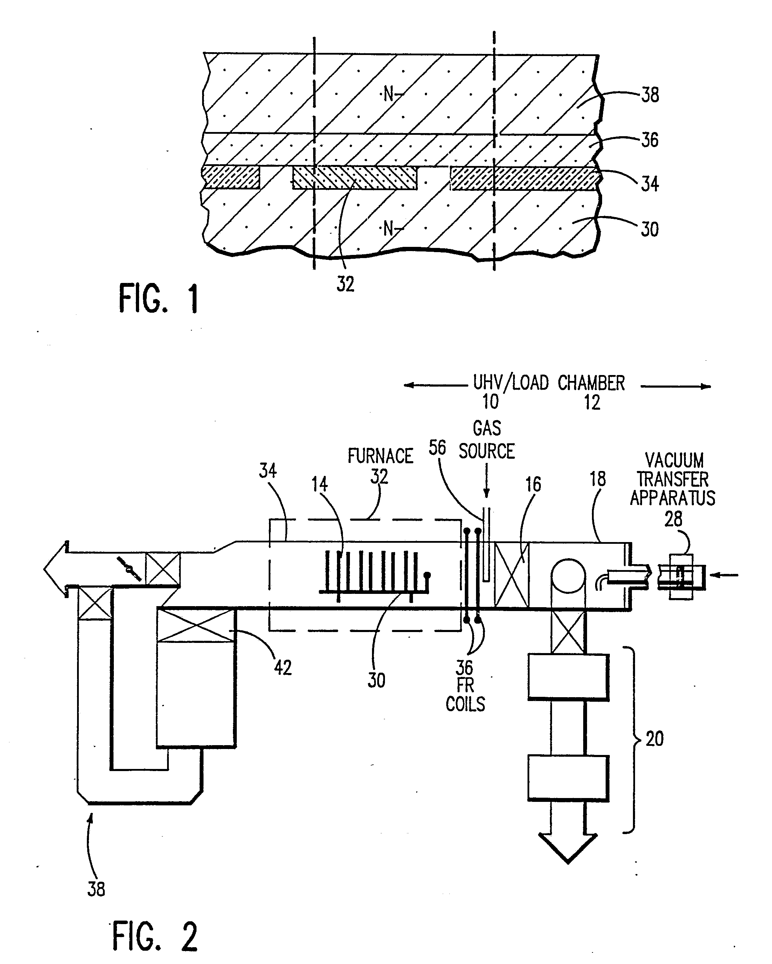

Referring now to Figure 1, Figure 1 is a cross-section view of an N- doped semiconductor substrate 30 containing two embedded doped regions 32 and 34 which are P + and N + respectively.

As shown in Figure 1, of this specific embodiment, substrate 1 is a monocrystalline silicon structure of conventional thickness and doped N- type to a resistivity of at least about 0.1 ohm-cm. Embedded in substrate 30 by conventional techniques is an N + type region 34 and a Pregion 32. Forming the N + region 34 may be accomplished in conjunction with well-known masking techniques by employing N-type impurities such as arsenic or phosphorous as the dopant to produce a high doping level which normally extends in the range of about $1 \times 10^{20}$ to about $1 \times 10^{21}$ atoms per cubic centimeter to provide a relatively low resistivity in the range of about $8 \times 10^{-4}$ to about $3 \times 10^{-4}$ ohm-cm. As shown, region 34 is of the same conductivity type as substrate 30.

Conversely, the P + region 32 defining the P/N junction may be formed, also in conjunction with masking techniques, by diffusion employing P-type impurities such as boron as the diffusant to produce a relatively high doping level which normally extends in the range of about $2 \times 10^{20}$ atoms per cubic centimeter to provide a corresponding low resistivity region in the range of about $7 \times 10^{-4}$ ohms-cm. As shown, the P + doped region 32 is of a conductivity type opposite to the conductivity of substrate 30. As will be understood, the foregoing illustrates the general applicability of the invention regardless the type or configuration of substrate employed. For example, the substrate may be devoid of doped regions, and thus merely comprise a doped region of one conductivity type on which is to be deposited semiconductor material of a second conductivity type to define a P/N junction. Also, either type of doped regions may be employed alone to the exclusion of the other type. In its broadest context the invention is also directed to deposition of doped semiconductor materials on a semiconductor substrate of the same conductivity type.

Next, as shown in Figure 1, a thin film (about 100Å) of N doped silicon 36 is deposited by a low temperature epitaxial technique. As high quality, low temperature epitaxial layers are recent techniques, the method and apparatus for deposition of this low temperature epitaxial layer is shown in detail in Figure 2.

Figure 2 is a layout plan for one type of low-temperature, low-pressure; CVD epitaxy growth apparatus.

In the figure, a UHV section 10 (deposition chamber, or reactor) and a load chamber section 12 is used to load substrates 14 into the UHV section 10. A main valve 16 serves as an isolation between UHV section 10 and the load chamber 12.

The function of loading chamber 12 is to provide a low-pressure chamber from which the substrates 14 are transferred into to UHV section 10 after the load chamber 12 has been pumped to a pressure below $10^{-6}$ Torr.

Loading chamber 12 is comprised of pumping means 20 for evacuating the chamber 12 to the desired vacuum level. Also attached to load chamber 12 is transfer means 28 for transferring the substrates 14 from the load chamber into the UHV section.

The UHV section (also termed a reactor, or deposition chamber) is generally comprised of a hot-wall furnace in which chemical vapor deposition onto the substrates occurs, and optionally instrumentation (mass spectrometer) for determining the impurity levels in the furnace, and pumping means for creating an ultimate vacuum at least $10^{-8}$ Torr in the furnace

Pumping means 38 is used to establish an ultimate vacuum at least $10^{-8}$ Torr in the tube 34. The provision of a load chamber means 12 and means 38 to provide an ultrahigh vacuum in the deposition tube of a CVD apparatus is essential to the deposition of epitaxial silicon layers of high quality onto the substrates 14. For this deposition, the source gases and any dopant gases are injected into tube 34 via the gas source inlet 56.

The major steps in the deposition process are the following:

1. The UHV section is pumped to a pressure which is less than about $10^{-8}$ Torr total pressure.

2. The substrates 14 are transferred from load chamber 12 to the UHV section 10, for epitaxial deposition thereon.

3. The desired operating temperature and pressure are established.

4. The source gas is introduced through inlet 56 in order to create an isothermal gas bath for uniform epitaxial deposition of silicon layers onto the substrates 14.

In the practice of this invention, the operating deposition temperature is less than about 800°C, and the operating total pressure is generally less than about 200 mTorr. Further, the apparatus is operated such that the partial pressures of all contaminants in UHV section 10 are maintained less than $10^{-8}$ Torr at all times, that is, prior to deposition and during deposition onto the substrates 14.

The basic operational steps of the invention have been described in the previous paragraphs with such description as to allow one skilled in the art to provide any further details necessary to practice a low temperature deposition process.

Referring again to Figure 1, onto the low-temperature epitaxial layer 36 is then deposited a N-layer 38.

The particular epitaxial growth method for this layer 38 is not critical and any of a number of conventional methods can be used.

The process for depositing medium to high temperature epitaxial layers are well known in the art (see SILICON PROCESSING FOR VISI ERA, VOL 1-PROCESS TECHNOLOGY, S. Wolf and R. N. Tauber, Lattice Press, Sunset Beach, Calif. (1987), pp. 124-160.

Epitaxial deposition equipment for these processes have included both vertical and pancake reactors using source gases such as $SiH_4$, $SiH_2Cl_2$, $SiHCl_3$ and $SiCl_4$ with $H_2$. Recent reviews describing processes suited for such deposition include (e.g. "Silicon Epitaxy," Nov. 1978, SOLID STATE TECHNOLOGY, pp. 103-106, respectively).

In this particular embodiment, the substrate is heated in a vertical reactor and the deposition is carried out at an operating pressure of 35 Torr at a temperature of 860°C employing $SiCl_4$ and $H_2$ as reactants. Arsine was employed as the dopant and introduced as a controlled trace gas at 50 ppm. The gases were passed over the substrate at 40 lpm until the desired thickness was achieved, which for practical purposes can normally extend in the range of about 1 to 5 microns.

It should be appreciated by those skilled in the art that higher temperatures (above 860°C) can be employed in any of these medium to high temperatures epitaxial deposition processes to achieve higher rates. Additionally, different source gases can provide higher rates.

As will be understood, where undoped epitaxial layers are desired, the dopant will be omitted from the feed gas; and conversely if an N-type epitaxial layer is desired a corresponding type of conductivity deter-mining impurity, such as phosphine or arsine may be added to the feed gas. In general, various dopant concentrations can be employed depending upon the desired characteristics of the deposited epitaxial layer.

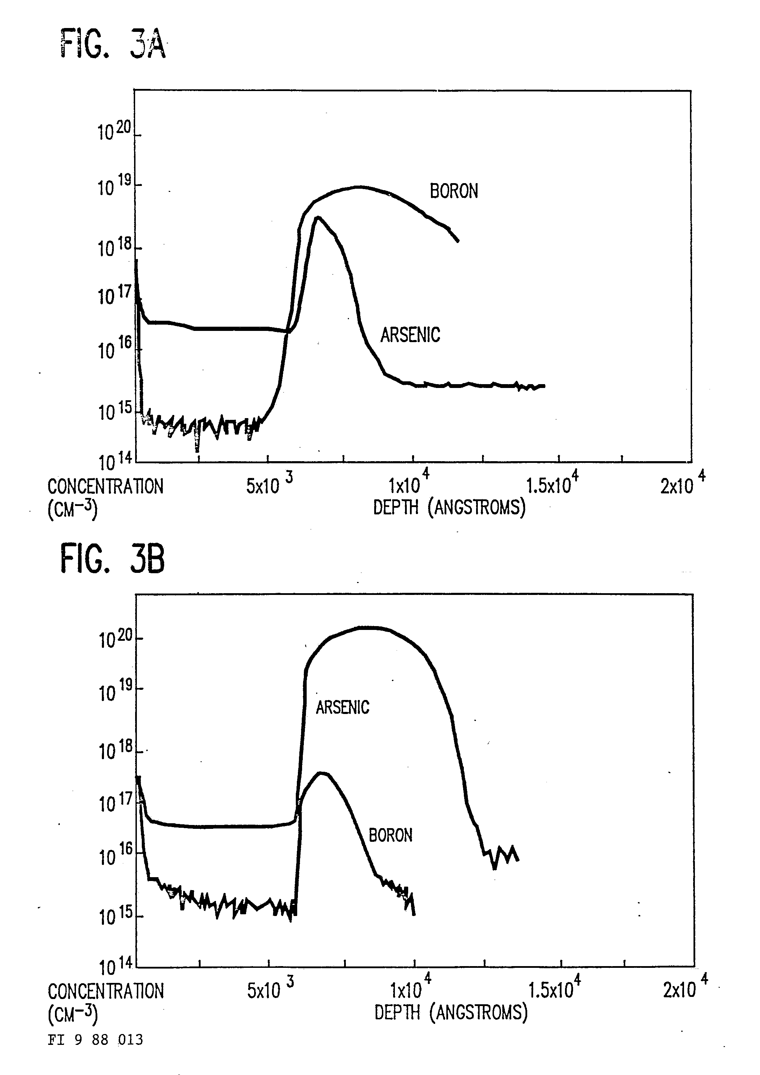

As a comparison of the improvements in the methodology of the present invention to that which is currently practiced in the art, a sample wafer with a doped substrate 30 and implants 32 and 34 was subjected to a conventional processed n- epi growth over the substrate surface at medium to high temperatures (greater than 850°C). Figure 3A is the SIMS profile for this N-epitaxial growth 38 over the P+ implant 32 (without the intervening low temperature epitaxial film 36 as shown in Figure 1) along the same cross-sections as indicated by the broken line in Figure 1. Figure 3B is the SIMS profile for the N- epitaxial growth 38 over the N+ implant 34 (again without the intervening low temperature epitaxial film 36 as shown in Figure 1) along the cross-section as indicated by its respective broken line. Both above regions are on substrate 30.

From Figure 3B, it can be seen that at about 6000Å into the epi deposition over the N+ implant 34 that out-gassing and diffusion from the N+ implant 34 caused a substantial increase in the boron doping of the N-epitaxial layer 38. It will be recognized by those skilled in the art that the boron doping of the N- layer is a result of diffusion and out-gassing with out-gassing comprising the major portion of the doping.

Even more critical are the results of the SIMS profile for Figure 3A of epitaxial growth 38 over the P+ implant 32. The profile shows that the arsenic has now out-gassed and diffused into the epitaxy 38 to a concentration nearly equal the concentration of the boron in the deposit. This is totally unacceptable for device formation.

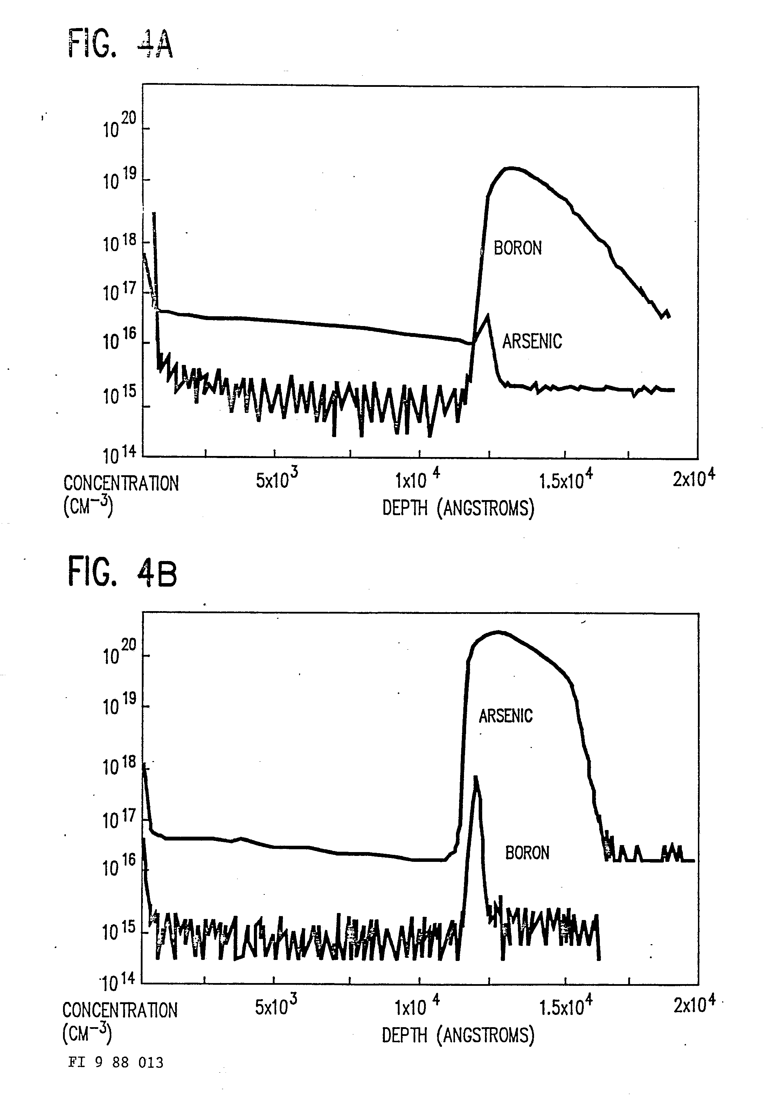

As a comparison to the conventional epitaxial deposit of Figures 3A and 3B, figures 4A and 4B show the SIMS curves for an embodiment of a medium temperature epitaxial layer deposited on a low-temperature layer on a similarly doped substrate.

Figures 4A shows the epitaxial deposit of an N-doped layer on a P+ substrate region along the same line as discussed above.

Returning now to Figure 1 for reference, in Figure 3A the growing of the N- epitaxial layer over the P+ (boron doped region) resulted in a significant autodoping of arsenic. This autodoping of arsenic was observed in the SIMS profile of Figure 3A wherein the epitaxial layer immediately above the P+ substrate showed an almost equal concentration of arsenic and boron in that region.

Now, however, referring to Figure 4A, the SIMS curve, for the same doping configuration of Figure 3A, has changed and improved with the layering of a low-temperature epitaxial layer 36 of about 400Å thick followed by the deposition of a medium temperature epitaxial layer 38 over layer 36.

From Figure 4A, the medium temperature N-epitaxial layer 38 is about $1 \times 10^4$ Å deep. The autodoping of the arsenic in the immediate surface boundary between layers 36 and 32 can now be seen to be significantly less than the boron concentration at the same boundary in Figure 3A. From Figure 4A, it can be seen that at a surface depth of $1.25 \times 10^4$ Å that the boron concentration is $10^{19}$/cm3 while the arsenic concentration has been controlled to under $10^{17}$/cm3. This is an extensive improvement in controlling auto-doping over that shown in Figure 3A for growing medium temperature epitaxial layers.

Similar results can be seen for Figure 4B for the growing of an N- doped layer on the N+ substrate. In Figure 4B, the N- doped region along the lines as discussed, can be seen to extend from the surface to about $1.25 \times 10^4$ Å. This epitaxial layer comprises a medium temperature epitaxial growth of about $1.200 \times 10^4$ Å . From Figure 4B, it can be seen that the boron autodoping at the boundary between layers 36 and 34 has also been better contained by the low temperature epitaxial layer 36. In actual devices, it is hypothesized that low temperature containment of boron in such configurations will be improved over using the medium temperature deposit as shown in Figure 3B. This is based on the fact that the deposits made for Figures 3A and 3B were with an initial high temperature bake which was not used in the fabrication of the devices of Figures 4A and 4B.

With the method of Figure 1, the depositions can now be performed within acceptable time limits. The low temperature processing time has been kept to a minimum as only a thin 400Å layer was deposited. The remaining thickness of epitaxial deposit was made up of the medium temperature growth which in comparison is about 20 times as fast as the low temperature growth. Conventional medium to high temperature depositions take place at about a rate of 1 micron/5 minutes as compared to 100Å /minute or 1 micron/100 minutes for low temperature deposits.

## Claims

1. A method for growing an epitaxial film on the surface of a semiconductor substrate comprising:

A) depositing a first layer to a thickness greater than 100Å by chemical vapor deposition under ultrahigh vacuum and at temperatures less than 800° C, and

B) depositing a second layer onto said said second layer being of a thickness greater than or equal to the thickness of said first layer until the desired epitaxial thickness is deposited and said second layer being deposited by chemical vapor deposition at temperatures greater than 800° C.

2. The method of Claim 1, wherein said total operating pressure for the deposition of said first layer is less than about 200 mTorr.

3. The method of Claim 2, wherein said deposition temperature for the deposition of said first layer is less than 700° C.

4. The method of Claim 1, wherein said substrate is comprised of silicon.

5. The method of Claim 1, wherein said first deposited layer is a single crystal silicon.

6. The method of Claim 5, wherein said gas used in the deposition of said first layer is silane.

7. The method of Claim 2, wherein the partial pressures of all containments in said apparatus are maintained at pressures less than $10^{-8}$ Torr.

8. The method of Claim 1, wherein said deposition temperature for deposition of said first layer is in the range of about 550-800° C and said total operating pressure of said gas containing silicon is less than 50 mTorr.

9. The method of Claim 1, including the further step of similarly doping said first and second layers in-situ to produce a n or p type conductivity region therein.

10. An epitaxial film on the surface of a semiconductor substrate grown by the process comprising the steps of:

A) depositing a first layer to a thickness greater than 100Å by chemical vapor deposition under ultrahigh vacuum and at temperatures less than 800° C, and

B) depositing a second layer onto said first layer said second layer being of a thickness greater than or equal to the thickness of said first layer until the desired epitaxial thickness is deposited and said second layer being deposited by chemical vapor deposition at temperatures greater than 800° C.

11. The epitaxial film of Claim 10, wherein said total operating pressure for the deposition of said first layer is less than about 200 mTorr.

12. The epitaxial film of Claim 11, wherein said deposition temperature for the deposition of said first layer is less than 700° C.

13. The epitaxial film of Claim 12, wherein said substrate is comprised of silicon.

14. The epitaxial film of Claim 13, wherein said first deposited layer is a single crystal silicon.

15. The epitaxial film of Claim 14, wherein said gas used in the deposition of said first layer is silane.

16. The epitaxial film of Claim 11, wherein the partial pressures of all containments in said apparatus are maintained at pressures less than $10^{-8}$ Torr.

17. The epitaxial film of Claim 10, wherein said deposition temperature for deposition of said first layer is in the range of about 550-800°C and said total operating pressure of said gas containing silicon is less than 50 mTorr.

18. The epitaxial film of Claim 10, including the further step of similarly doping said first and second layers in-situ to produce a n or p type conductivity region therein.

N—

38

36

34

N—

30

32

## FIG. 1

UHV/LOAD CHAMBER
10            12

GAS
56    SOURCE

FURNACE
34      32                      16      18      VACUUM
14                                              TRANSFER
                                                APPARATUS
                                                28

42        30        36
                    FR
                    COILS

20

38

## FIG. 2

## FIG. 3A

CONCENTRATION
(CM$^{-3}$)

DEPTH (ANGSTROMS)

## FIG. 3B

CONCENTRATION
(CM$^{-3}$)

DEPTH (ANGSTROMS)

FI 9 88 013

## FIG. 4A

## FIG. 4B

FI 9 88 013